# EUROPÄISCHE PATENTSCHRIFT

(11) **EP 2 789 015 B1**
(45) Veröffentlichungstag und Bekanntmachung des Hinweises auf die Patenterteilung: **12.08.2015**
(21) Anmeldenummer: 12812512.7
(22) Anmeldetag: 06.12.2012
(51) Int. Cl.: H01L 31/0232

(54) **VERFAHREN UND VORRICHTUNG ZUR INDUSTRIELLEN HERSTELLUNG VON PHOTOVOLTAISCHEN KONZENTRATORMODULEN**
METHOD AND DEVICE FOR INDUSTRIALLY PRODUCING PHOTOVOLTAIC CONCENTRATOR MODULES
PROCÉDÉ ET DISPOSITIF DE FABRICATION INDUSTRIELLE DE MODULES CONCENTRATEURS PHOTOVOLTAÏQUES

(30) Priorität: 08.12.2011 DE 202011108836 U
(43) Veröffentlichungstag der Anmeldung: 15.10.2014
(73) Patentinhaber: Grenzebach Maschinenbau GmbH, 86663 Asbach-Baeumenheim (DE); Soitec Solar GmbH, 79111 Freiburg (DE)
(72) Erfinder: SCHMID, Markus, 85555 Burgheim (DE); FEINEIS, Alexander, 86609 Donauwörth (DE)
(74) Vertreter: Kindermann, Peter
(86) Internationale Anmeldenummer: PCT/DE2012/001160
(87) Internationale Veröffentlichungsnummer: WO 2013/083111

(56) Entgegenhaltungen:
- US-A1- 2002 140 079
- US-A1- 2007 263 289
- US-A1- 2010 011 565

## Beschreibung

Bereits seit vielen Jahren gibt es in der Photovoltaik Ansätze, mit konzentrierter Solarstrahlung zu arbeiten. Hierbei wird die Strahlung der Sonne mittels Spiegeln und / oder Linsen konzentriert, und auf spezielle Konzentrator - Solarzellen gerichtet.

Entsprechende Systeme konzentrierender Photovoltaik ( Concentrating Photovoltaics, CPV ) werden derzeit im spanischen Solarforschungsinstitut Instituto de Sistemas Fotovoltaicos de Concentracion ( ISFOC ) in Kastilien bei Puertollano getestet. Sie bündeln das Sonnenlicht mit Linsen oder Spiegeln auf die vierhundertbis tausendfache Intensität, bevor es auf kleine Solarzellen trifft, die deutlich effizienter sind als klassische Silizium - Solarzellen. Hersteller aus vielen Teilen der Welt haben auf dem dortigen Testgelände CPV - Module installiert. Derzeit sind auf dem Gelände etwa tausend Module installiert. Die Forscher entwickeln unter anderem Ertragsprognosen und testen die Langzeitstabilität, um dieser Technologie den Übergang aus der Entwicklung in die Märkte zu erleichtern. Das Dokument US 2010/011565 A beschreibt photovoltaische Vorrichtungen.

Bisher sind weltweit nur wenige CPV - Anlagen in Betrieb. Ihre Gesamtleistung von etwa 30 Megawatt entspricht ungefähr der Leistung von drei Kernkraftwerken. Eine aktuelle Studie des amerikanischen Marktforschungsinstituts Greentechmedia Research sagt dieser Technologie aber eine steigende Karriere voraus. Danach könnte die pro Jahr installierte CPV - Leistung schon 2015 bei 1000 Megawatt liegen. Unter günstigen Bedingungen kostet eine Kilowattstunde Strom aus CPV - Anlagen, einer Studie des Fraunhofer- Instituts für Solare Energiesysteme ( ISE ) in Freiburg zufolge, zwischen 18 und 21 Cent je Kilowattstunde. Es wird fest mit weiteren Kostensenkungen durch effizientere Komponenten und eine ausgereifte industrielle Produktion gerechnet.

Das Herzstück der Anlagen sind die Hochleistungssolarzellen, die derzeit vor allem im Weltraum im Einsatz sind. Dort versorgen sie schon seit Jahren Satelliten und Roboter mit Strom. Statt Silizium enthalten diese Zellen so genannte Verbindungshalbleiter aus Gallium, Indium, Arsen oder Phosphor. Sie bestehen aus mehreren verschiedenen Halbleiterschichten, von denen jede einen anderen Bereich des Sonnenlichtspektrums verarbeitet, während klassische Siliziumzellen nur einen geringeren Teil des Sonnenlichtspektrums in elektrischen Strom umwandeln können.

Aus der Patentliteratur wird folgender Stand der Technik genannt.

In der US 4 834 805 A wird ein photovoltaisches Kraft - Modul offenbart mit den folgenden Merkmalen.

Einer Anordnung von photovoltaischen Halbleiter - Kristallzellen, verteilt in individuellen Zell - Standorten in einem geschichteten Substrat, wobei sie von zwei elektrisch leitenden Schichten eingeschlossen und mittels einer Isolierschicht getrennt sind. Ferner besteht dieses Modul aus einer lichtfördernden Schicht aus Linsen die in einer Entfernung zu dem geschichteten Substrat angeordnet ist, wobei einfallende Strahlung in der lichtfördernden Schicht mittels der Linsen in das Substrat fokussiert wird, und wobei die Dicke der Linsenschicht, der Substratschicht und des Raums dazwischen weniger als 2 inch beträgt.

Aus der DE 10 2006 007 472 A1 ist ein photovoltaisches Konzentratormodul mit einer Linsenplatte und einer Bodenplatte, auf welcher Solarzellen untergebracht sind, und einem Rahmen bekannt, wobei der Rahmen die Linsenplatte und die Bodenplatte verbindend, längs des Randes der Linsenplatte und der Bodenplatte umlaufend angeordnet ist.

Diese bekannte Konzentratormodul soll dahingehend verbessert werden, dass es kostengünstig hergestellt werden kann, langlebig ist, und dass es erlaubt, einfach und flexibel zusätzliche Komponenten zu integrieren die auf der Linsenplatte oder der Bodenplatte nicht oder nur schwierig untergebracht werden können. Darüber hinaus soll ein Verfahren entwickelt werden, das die Herstellung solcher Konzentratormodule ermöglicht.

Die hier gestellte Aufgabe wird dadurch gelöst, dass entlang des Rahmens zwischen der Linsenplatte und dem Rahmen und/oder der Bodenplatte und dem Rahmen zum einen mindestens eine erste Dichtmasse und/oder Klebemasse und zum anderen mindestens eine zweite Dichtmasse zumindest auf einem Teil der Länge des Rahmens umlaufend angeordnet ist, wobei die beiden Dicht - und/oder Klebenassen sich bezüglich ihrer Aushärtezeit und/oder Gasdurchlässigkeit unterscheiden.

Im Anspruch 57 wird ein Verfahren zur Herstellung eines photovoltaischen Konzentratormoduls nach einem der vorhergehenden Ansprüche beansprucht, das durch die folgenden Merkmale gekennzeichnet ist.

Nämlich, dass ein Rahmen, eine Linsenplatte und eine Bodenplatte verbindend, längs dem Rand der Linsenplatte und der Bodenplatte angeordnet wird, und dass zwischen den Rahmen und die Linsenplatte und/oder den Rahmen und die Bodenplatte zu einen mindestens eine erste Dichtmasse und/oder Klebemasse und zum anderen mindestens eine zweite Dichtmasse entlang des Rahmens über zumindest einen Teil seiner Länge umlaufend , eingebracht wird, wobei die beiden Dicht - und/oder Klebemassen sich bezüglich ihrer Aushärtezeiten und/oder Gasdurchlässigkeiten unterscheiden. Es ist zwar hier von einer ersten Dichtmasse und/oder Klebemasse und einer zweiten Dichtmasse die Rede, aber dass eine der Klebemassen lediglich zur Fixierung einer Platte während des Herstellungsprozesses mittels UV - Licht dient, während eine andere, langlebige, Klebemasse zur Hauptabdichtung verwendet wird, ist hier nicht zu entnehmen.

Der erfindungsgemäßen Vorrichtung bzw. dem entsprechenden Verfahren liegt die Aufgabe zugrunde, eine Vorrichtung und ein Verfahren vorzustellen mit dem Konzentratormodule industriell preiswert und zuverlässig hergestellt werden können

Diese Aufgabe wird mit einer Vorrichtung nach Anspruch 1 gelöst. Weitere vorteilhafte Ausführungen sind in den Ansprüche 2-8 beschrieben.

Die erfindungsgemäße Vorrichtung wird im Folgenden näher beschrieben. Es zeigen dabei im Einzelnen:
Fig.1: einen Modulrahmen 1 in der Draufsicht
Fig.2: ein Konzentratormodul im Querschnitt
Fig.3: eine Linsenscheibe mit Fresnel - Linsen 5
Fig.4 eine Übersicht über eine erfindungsgemäße Fertigungsanlage
Fig.5: eine Draufsicht auf eine Lafette 30
Fig.6: eine Darstellung einer Auflege - Einrichtung
Fig.7: einen Querschnitt eines Saugerträgers 39
Fig.8: einen Querschnitt eines Saugers 41
Fig.9: eine erläuternde Darstellung eines Klebevorgangs
Fig.10: eine erläuternde Darstellung der Fixierung einer Sensorträgerscheibe

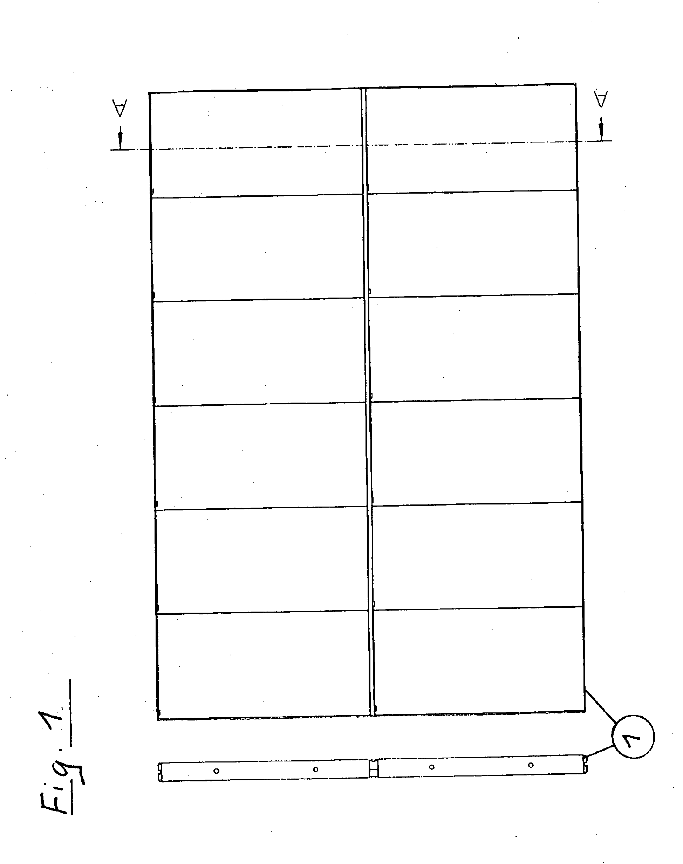

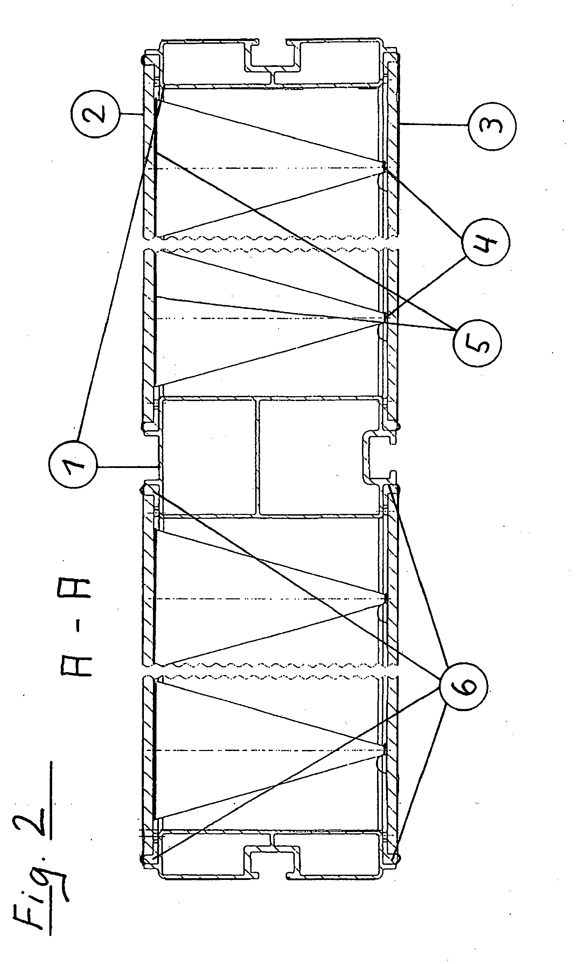

In der Fig.1 ist ein Modulrahmen ( 1 ) in der Draufsicht gezeigt. Der Schnitt A - A stellt die Blickrichtung der Seitenansicht dar, die in der Fig.2 zu sehen ist. Der Modulrahmen ist über Querstege in die gezeigten Felder unterteilt.

Die Fig. 2 zeigt ein Konzentratormodul mit seinem tragenden Modulrahmen ( 1 ) im Querschnitt in vergrößerter Darstellung. Auf der Oberseite sind hier jeweils eine Linsenscheibe 2 und an der Unterseite als Bodenscheibe eine entsprechende Sensorträgerscheibe 3 zu erkennen. Der Modulrahmen 1 ist hierbei auf jeder Seite in seiner Querausdehnung unterbrochen dargestellt, um die gezeigten Einzelheiten in den wahren Größenverhältnissen zeigen zu können. In der Linsenscheibe 2 finden sich auf der rechten Seite Hinweise auf die verwendeten Fresnel - Linsen 5, und in der Sensorträgerscheibe auf die entsprechenden CPV- Sensoren 4. In der Fig.2 sind auch deutlich auf der linken Seite die Bereiche des Auftrags einer Silikondichtung 6 markiert.

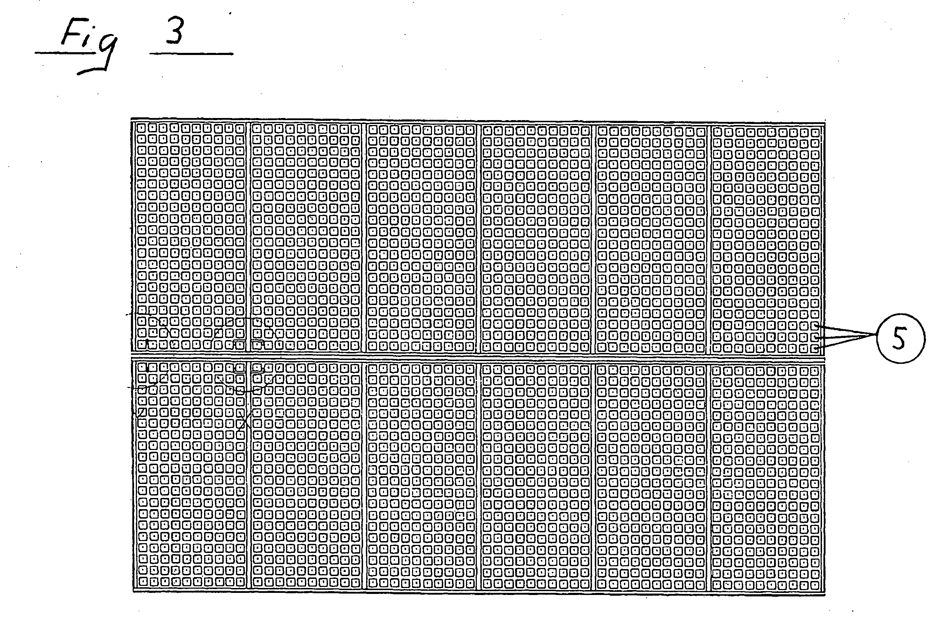

Die Fig. 3 zeigt eine Linsenscheibe mit allen in dieser Größe eines Modulrahmens 1 eingebauten Fresnel - Linsen ( 5 ). Auf der rechten Seite sind 3 dieser Fresnel - Linsen 5 gesondert bezeichnet. Auf der linken Seite sind in den gezeichneten Kreisen die Anschlüsse der Flachbandkabel dargestellt die den gesamten Strom der einzelnen CPV - Sensoren 4 jedes der gezeigten Felder zusammenführen, und die in der Mitte längs eines Modulrahmens 1 weitergeleitet werden.

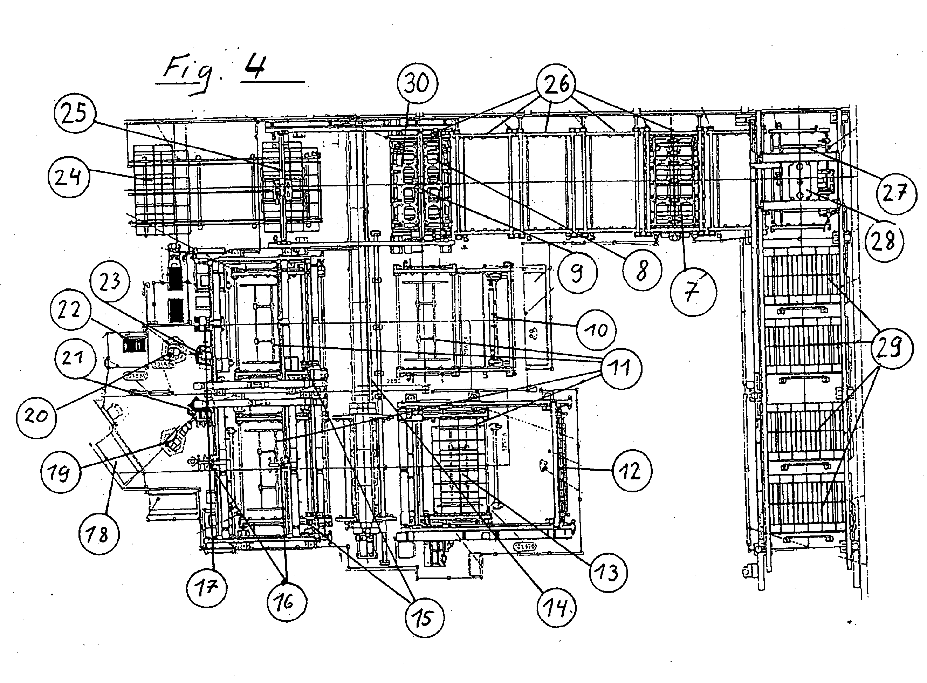

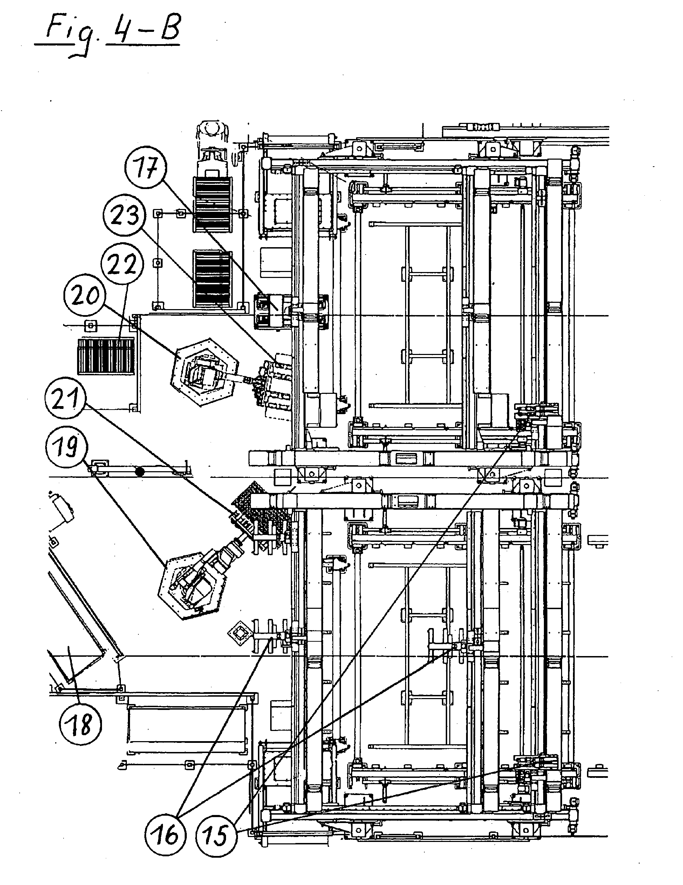

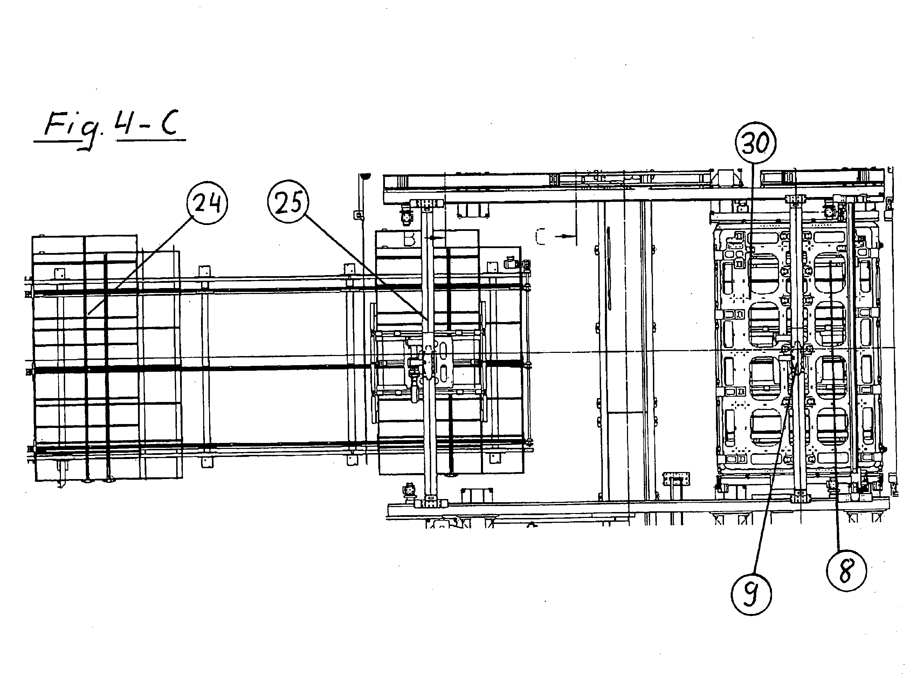

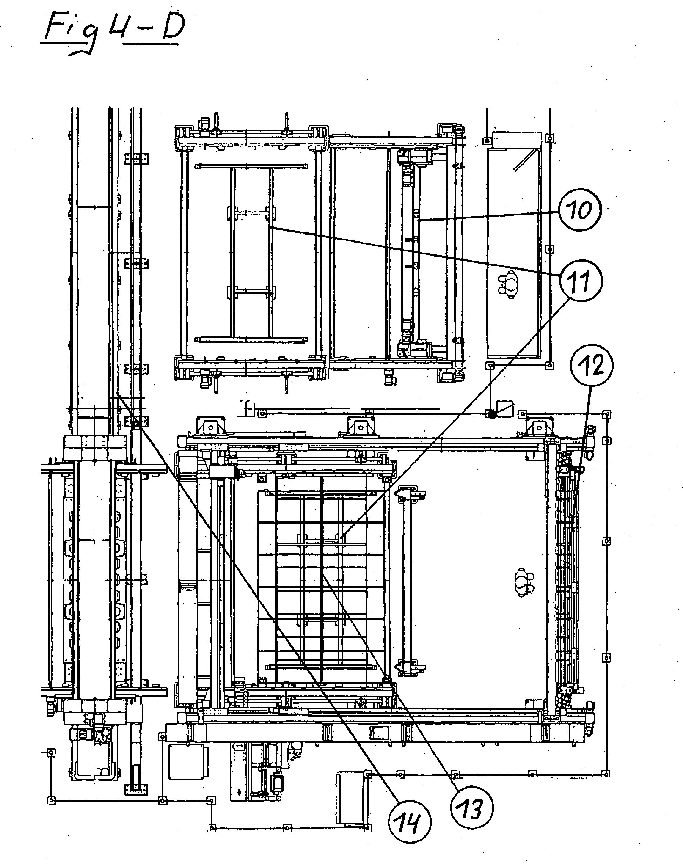

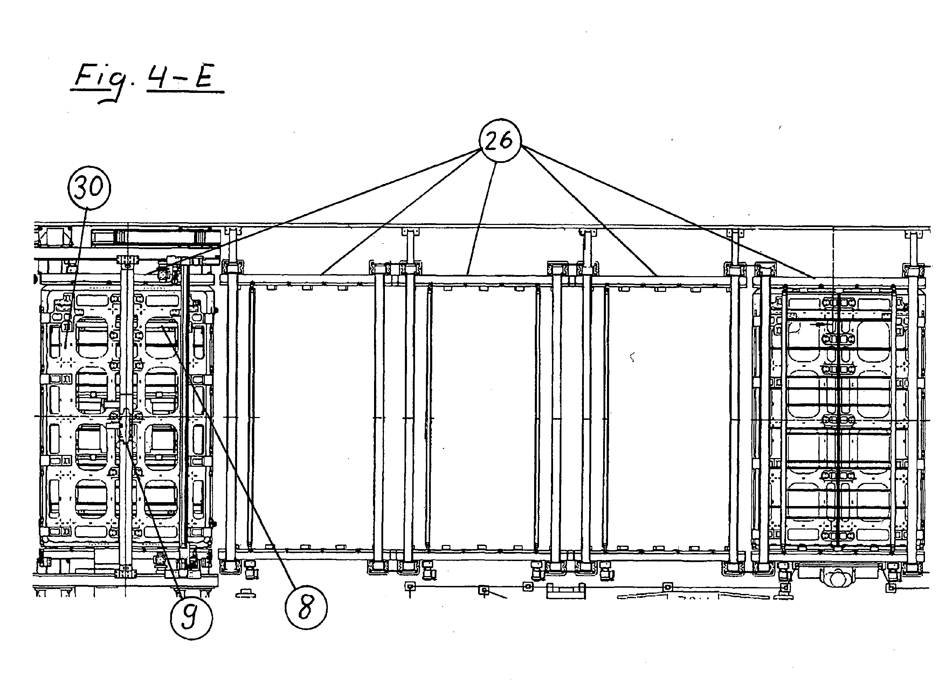

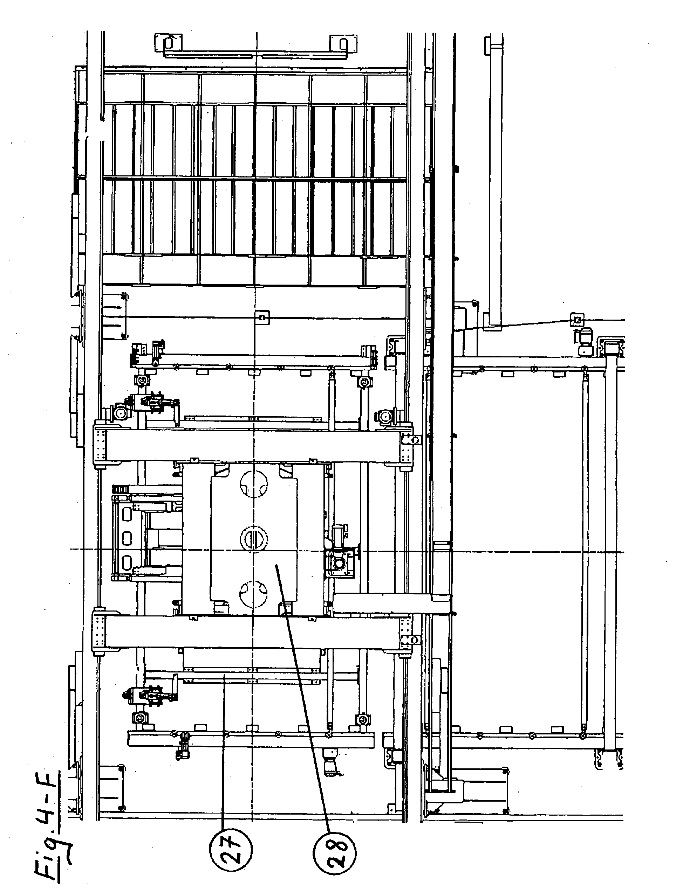

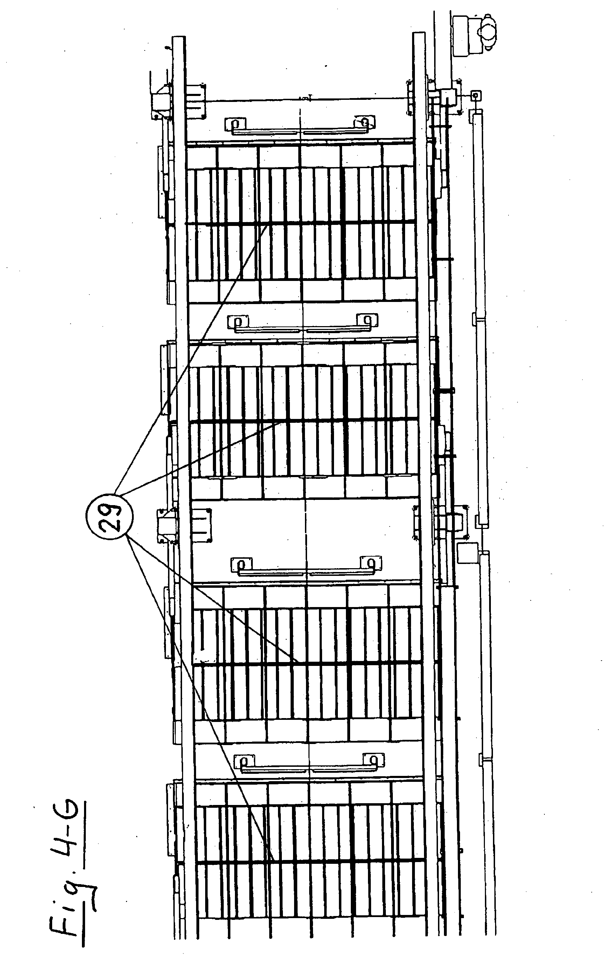

Die Fig. 4 bietet eine Übersicht über eine Fertigungsanlage zur industriellen Herstellung von photovoltaischen Konzentratormodulen.
An der linken oberen Ecke der Fig.4 ist ein Magazin 24 für Modulrahmen 1 zu erkennen. Mit 25 ist benachbart weiter ein Portalumsetzer für Modulrahmen 1 bezeichnet. Der Portalumsetzer 25 übernimmt Modulrahmen 1 aus dem Magazin 24 und gibt diese an eine Auflegeeinrichtung 9 weiter. Hierbei wird ein Hubtisch 8 mit 5 Ebenen verwendet. Diese Auflegeeinrichtung 9 setzt dann jeweils einen Modulrahmen 1 auf eine Lafette 30, die zusammen auf dem Querförderer 14 zu der Vorrichtung 15 zum Auftrag von Acryl 46 und Silikon 6 verfahren werden. Hier werden Acrylpunkte und eine entsprechende Silikonraupe auf die jeweils oben liegende Seite eines Modulrahmens 1 aufgetragen.

Hierauf wird eine Sensorträgerscheibe 3 als Bodenplatte aufgesetzt. An diesem Vorgang ist das Magazin 18 für Sensorträgerscheiben 3, der Übergaberoboter 19 für Sensorträgerscheiben 3 und die Auflege - Einrichtung 16 für Sensorträgerscheiben 3 beteiligt. Die Sensorträgerscheibe 3 wird mittels der Vorrichtung 16, zentral auf der jeweiligen Scheibe ansetzend, mit einem vorbestimmten Anpressdruck angedrückt, und dann durch die Aushärtung der Acrylpunkte mittels UV - Licht am Modulrahmen 1 fixiert. Eine solche Fixierung ist dem Stand der Technik nicht zu entnehmen. Die entsprechenden Herstellungsvorgänge werden später näher erläutert.

Die Lafette 30 mit dem so ausgestatteten Modulträger 1 wird zur mechanischen, oder je nach Ausbaustufe auch automatischen, Kontaktierung 13 gefahren. Dort wird der Modulrahmen von der Lafette 30 entfernt, von der horizontalen Lage in eine vertikale Position gedreht, und zur manuellen Kontaktierung der Station 12 befördert. Hier wird im Wesentlichen ein Verteilerkasten für die elektrischen Verbindungsleitungen eingebaut. Die folgende elektrische Verbindung der CPV - Sensoren mit dem Verteilerkasten kann manuell oder automatisch erfolgen. Anschließend wird der Modulrahmen 1 wieder in eine horizontale Lage gedreht, sodass die Sensorträgerscheibe 3 unten liegt, und auf einer Lafette 30 befestigt.

Die Lafette 30 mit dem so ausgestatteten Modulträger 1 wird sodann zu der Vorrichtung 15 zum Auftrag von Acryl 46 und Silikon 6 verfahren. Hier werden Acrylpunkte und eine entsprechende Silikonraupe aufgetragen.

Hierauf wird eine Linsenscheibe 2 aufgesetzt. An diesem Vorgang ist das Magazin für Linsenscheiben 22, der Übergaberoboter 20 für Linsenscheiben und die Auflege - Einrichtung 17 für Linsenscheiben beteiligt. Die entsprechenden Herstellungsvorgänge werden später näher erläutert. Die einzelnen Bearbeitungsstationen sind mit Hubtischen 11 ausgerüstet. Diese Hubtische 11 dienen dem reibungslosen Transport von Lafetten 30 und Modulträgern 1 während des Betriebsablaufs und ermöglichen das zeitweilige Verlagern von Bauteilen in ein Zwischengeschoß.

Für eine einwandfreie Funktion des Konzentratormoduls ist eine exakte Ausrichtung der Fresnel - Linsen 5 auf die entsprechenden CPV - Sensoren 4 erforderlich. Die Justierung der Linsenscheiben 2 erfolgt mittels einer Kamera ( 49 ). Der technische Vorgang hierzu wird später erläutert.

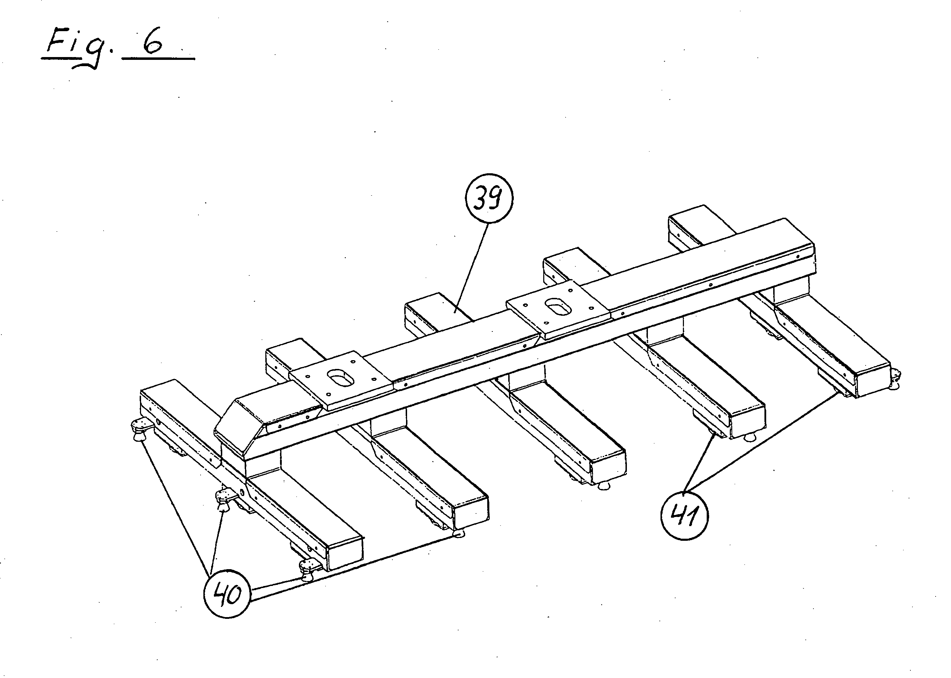

Nach der Fein - Justierung einer Linsenscheibe 2 erfolgt die Fixierung der Linsenscheibe 2 mittels Aushärtung der Acrylpunkte durch Bestrahlung mit einem UV - Lichtstrahler 40 ( vgl. Fig. 6 ).

Die Lafette 30 wird dann zur Station 10 verfahren, wo sie in eine vertikale Lage gebracht wird. Dann wird das überschüssige Silikon manuell oder automatisch von der vertikal orientierten Lafette 30 entfernt

Von der Station 10 aus wird die so behandelte Lafette 30 mittels des Querförderers 14 zu einer Qualitätsprüfung verfahren.

Nach der Qualitätsprüfung wird die entsprechende Lafette 30 in die Lagerstation 26 verfahren, die Plätze in mehreren Ebenen aufweist, wobei auch eine Ebene für Leerpaletten vorgesehen ist. Hier hat das Silikon die erforderliche Zeit, um aushärten zu können.

Nach der Aushärtezeit wird jedes Konzentratormodul mit einem bar - code versehen und mittels eines Hubtisches 27 und eines Portalumsetzers 28 auf Abstapelplätze 29 verbracht, die eine Einordnung nach Qualitätsstufen erlauben.

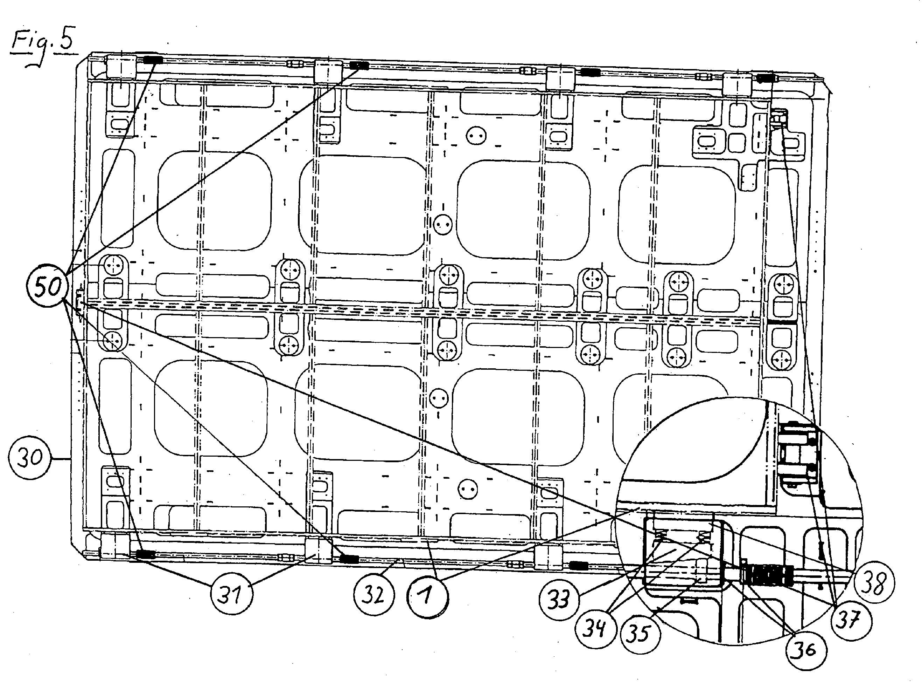

Fig.5 zeigt eine Draufsicht auf eine Lafette 30. Die gestrichelten Linien kennzeichnen hier einen aufgesetzten Modulrahmen 1. Der Modulrahmen 1 ist hierbei auf der oberen Längsseite mittels derselben Spannelemente 31 befestigt wie die, an der unteren Längsseite im Detail bezeichneten. Auf der linken Breitseite in der Mitte, an der Stelle des verstärkten Mittelstegs des Modulrahmens 1, ist ein Spannriegel 37 vorgesehen, der den beiden, auf der rechten Breitseite bezeichneten Spannriegeln 37 entspricht. Diese Spannriegel weisen eine konisch abgeschrägte Gleitfläche auf, die ein passgenaues Einsetzen und eine leichte Entnahme eines Modulrahmens 1 von oben mittels eines Greifers ermöglichen. In der in einem Kreis vergrößert heraus gezeichneten Detaildarstellung ist beispielhaft das Funktionsprinzip einer Spannvorrichtung zu erkennen. In der oberen Hälfte dieses Kreises ist die rechte untere Ecke des Modulrahmens 1 vergrößert gezeigt. Das ebenfalls vergrößert gezeigte, etwa quadratisch gestaltete, Spannelement 31 lässt eine, allen 4 Spannelementen 31 auf dieser Seite gemeinsame, Schaltstange 32 erkennen.

Im Folgenden wird das hier realisierte Wirkprinzip näher erläutert.

Auf dieser Schaltstange 32 sitzt eine Exzenter - Scheibe 35 die an einem abgeschrägten Schiebekeil 33 angreift, der wiederum über 2 Druckfedern 34 mit einem Anschlagelement 37 in Verbindung steht, das auf den Modulrahmen 1 drückt. Wird die Schaltstange 32, in diesem Fall nach links, verschoben, verschiebt sich auch die Exzenterscheibe 35 nach links und drückt, an dem Schiebekeil 33 entlang gleitend, die Druckfedern 34 zusammen, die diesen Druck elastisch an den Modulrahmen 1 weiter geben. Die beiden Magnete 36 verbinden sich miteinander und fixieren somit beispielhaft diese Grundeinstellung.

Diese Grundeinstellung kann manuell oder automatisiert vorgenommen werden.

Für eine automatisierte Verschiebung der Schaltstange 32 sind dem Fachmann viele Möglichkeiten bekannt, sie werden deshalb nicht näher beschrieben.

Eine weitere Verstellmöglichkeit dieser, im Prinzip dargestellten, Anordnung besteht darin, die Schaltstange 32 zu drehen und somit über die Drehung der Exzenterscheibe 35 eine zusätzliche Einstellung, insbesondere eine Feineinstellung, vorzunehmen.

Auch dies kann manuell oder automatisiert vorgenommen werden.

Zum Zweck einer automatisierten Einstellung kann mittels des dargestellten Stellmotors 50, auf der rechten Seite eines Spannelements 31, die Schaltstange 32 zusätzlich zu der beschriebenen Verschiebung, an der bezeichneten Stelle gedreht werden. Die auf der anderen Seite eines Spannelements 31 gezeigte Muffe dient der fertigungstechnischen Zusammensetzung der Schaltstange 32. Solche Stellmotore 50 befinden sich in diesem Fall an jedem Spannelement 31. Diese Verstelloption ermöglicht es, zusätzlich zu einer bestimmten Grundeinstellung, sei sie nun manuell oder automatisiert vorgenommen, den Anpressdruck jedes Spannelements 31 individuell automatisiert einzustellen. Über entsprechende, hier aus Gründen der übersichtlichen Darstellung nicht gezeigte und bezeichnete, Abstands - Sensoren und korrespondierende Drucksensoren, kann somit an jeder Stelle der Längsseite eines Modulrahmens 1 mittels dieser Spannelemente 31 derselbe individuelle Anpressdruck eingestellt werden. Auf der andern Längsseite sind die gleichen Spannelemente 31 mit den beschriebenen Vorrichtungen verbaut. Diese Maßnahme bewirkt, dass auch sehr leichte Verformungen der Seitenwände eines Modulrahmens 1 bei der Einspannung automatisch berücksichtigt werden können, somit eine völlig spannungsfreie Lagerung eines Modulrahmens 1 gewährleistet ist, und sich deswegen jeweils eine Linsenscheibe 2 und eine Sensorträgerscheibe 3 völlig spannungsfrei mit einem Modulrahmen 1 verbinden lassen. Diese Maßnahme gewährleistet, dass sich die Kräfte die bei großen Temperaturunterschieden auf die Verklebung dieser Scheiben einwirken, minimieren lassen. Hieraus ergibt sich eine sehr geringe Beanspruchung der Verklebung eines Konzentratormoduls und eine Erhöhung seiner Lebensdauer auch unter schweren klimatischen Anforderungen.

Die Fig.6 zeigt eine Darstellung einer Auflege - Einrichtung, mit jeweils 5 Saugerträgern 39, als Teil eines Übergabevorgangs mittels eines Übergaberoboters 19 für Sensorträgerscheiben 3, bzw. mittels eines Übergaberoboters 20 für Linsenscheiben 2. Ein Übergaberoboter weist hierbei generell einseitig 4 Saugträger auf, mit denen er jeweils eine Scheibe einseitig erfasst und diese an eine Auflege - Einrichtung übergibt. Eine Auflege - Einrichtung weist generell 5 Saugträger 39 auf. Die Übergabe einer Scheibe mittels eines Übergaberoboters erfolgt dadurch, dass die Scheibe mittels 4 Saugträgern einseitig gehalten, vom Übergaberoboter in die 4 Zwischenräume eines Saugträgers einer Übergabe - Einheit mit 5 Saugträgern 39 geschoben wird, und diese dann von der Übergabe - Einheit beidseitig angesaugt wird. Diese Saugerträger 39 tragen jeweils an ihren beiden Enden Sauger 41 und UV - Lichtstrahler 40, wobei UV - Lichtstrahler 40 auch jeweils in der Mitte eines Saugträgers 39 angebracht sind.

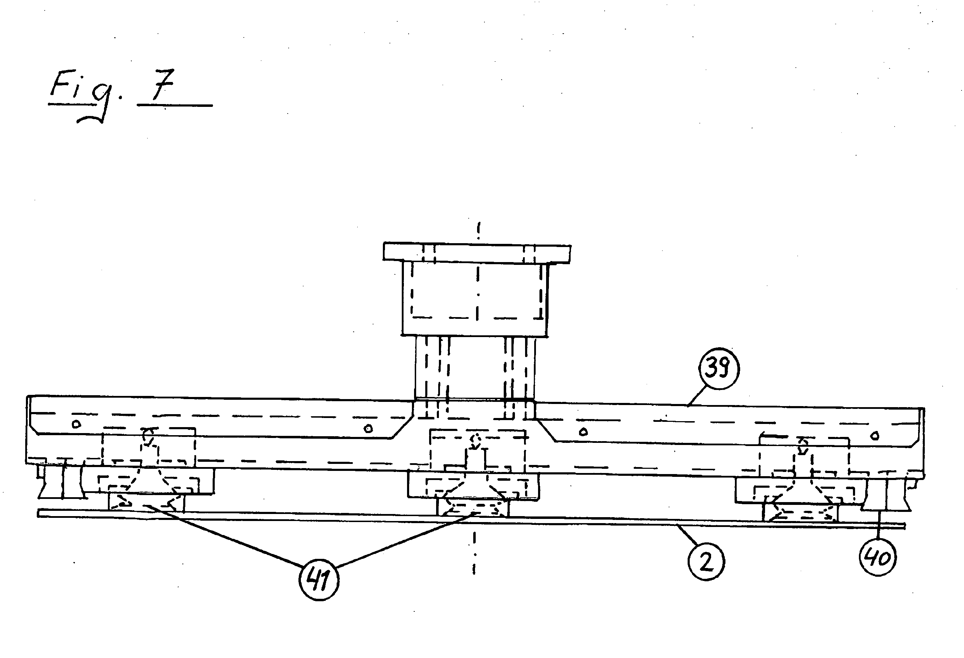

Die Fig.7 zeigt einen Querschnitt eines Saugerträgers 39. Zusätzlich zur Darstellung der Fig.6 ist hier eine aufgenommene Sensorträgerscheibe 2 gezeigt. Die beiden UV - Lichtstrahler 400 links und rechts sind hier im Querschnitt zu erkennen. Die mittleren UV - Lichtstrahler 40 sind verdeckt.

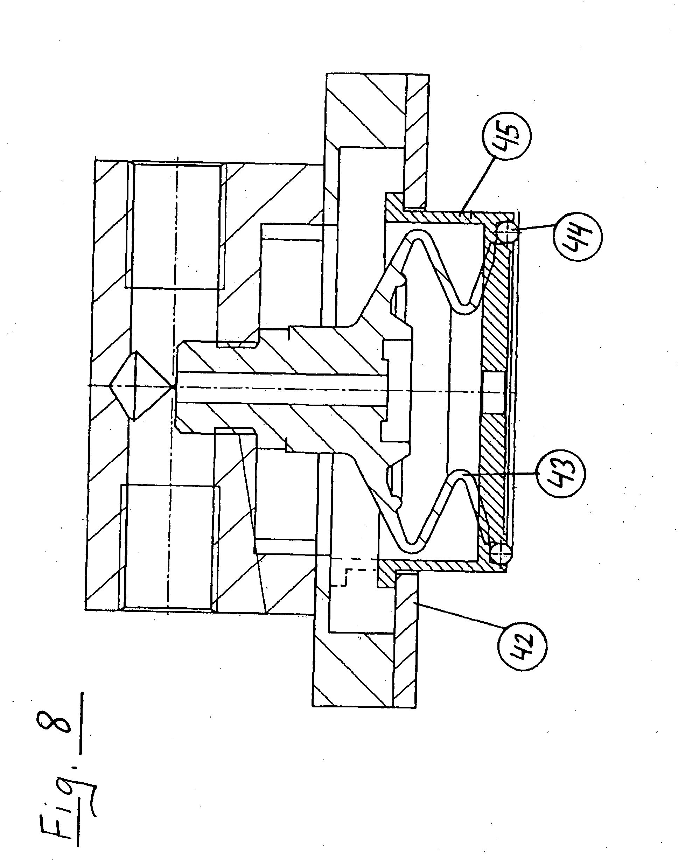

Die Fig. 8 zeigt einen Querschnitt eines Saugers 41. In dieser Darstellung ist die spezielle Wirkung dieses Saugers zu erkennen. Da es bei den aufzunehmenden Scheiben, vor allem bei der Sensorträgerscheibe 3, wichtig ist, dass diese absolut in ebener Lage transportiert und aufgebracht werden, muss auch bei jedem Saugerkopf die Fläche mit der die jeweilige Scheibe von dem jeweiligen Saugerkopf berührt wird, absolut eben sein. Dies wird dadurch erreicht, dass in der gezeigten Darstellung der Dichtring 44 in einem Saugerkopf 45 aus festem Material geführt ist. Der Saugerkopf 45 gleitet hierbei zusammen mit dem Gummibalg 43 in der Halteplatte 42. Ein wellenförmiges Verbiegen der aufgenommenen Scheibe an den Stellen der Angriffspunkte der jeweiligen Sauger, wie bei anderen Ausführungen im Stand der Technik mit flexibler Dichtlippe zu befürchten, ist hierbei ausgeschlossen. Der Saugerkopf 45 kann hierbei zum Beispiel auch annähernd quadratisch sein oder eine andere beliebige Flächenform aufweisen, die in der jeweils aufgenommenen Scheibe möglichst wenig mechanische Spannung induziert. So kann zum Beispiel in diesem Zusammenhang eine elliptisch geformte Fläche zur Reduzierung der Spannungen während der Aufnahme und des Transports in der jeweiligen Scheibe beitragen

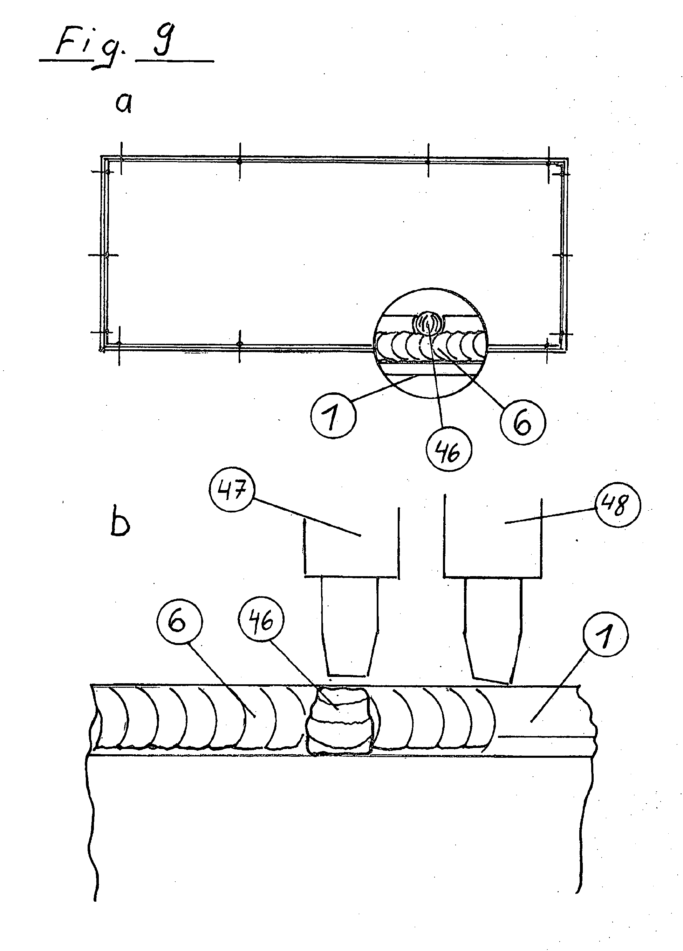

Die Fig.9 bietet eine erläuternde Darstellung eines Klebevorgangs. In der Fig.9a ist hier eine Detailansicht der umlaufenden Kante eines Modulrahmens 1 zu sehen, der an einer Stelle eine kreisförmige Detailansicht zeigt. Hier ist im Detail der Rand eines Modulrahmens 1 zu erkennen und der benachbarte Auftrag einer Silikon - Raupe 6. Dicht neben dieser Silikondichtung 6 ist ein Acrylpunkt 46 zu sehen.

In Fig.9b ist zusätzlich eine Acrylauftrag - Einrichtung 47 und eine Silikonauftrag - Einrichtung 48 in einer Seitenansicht gezeigt.

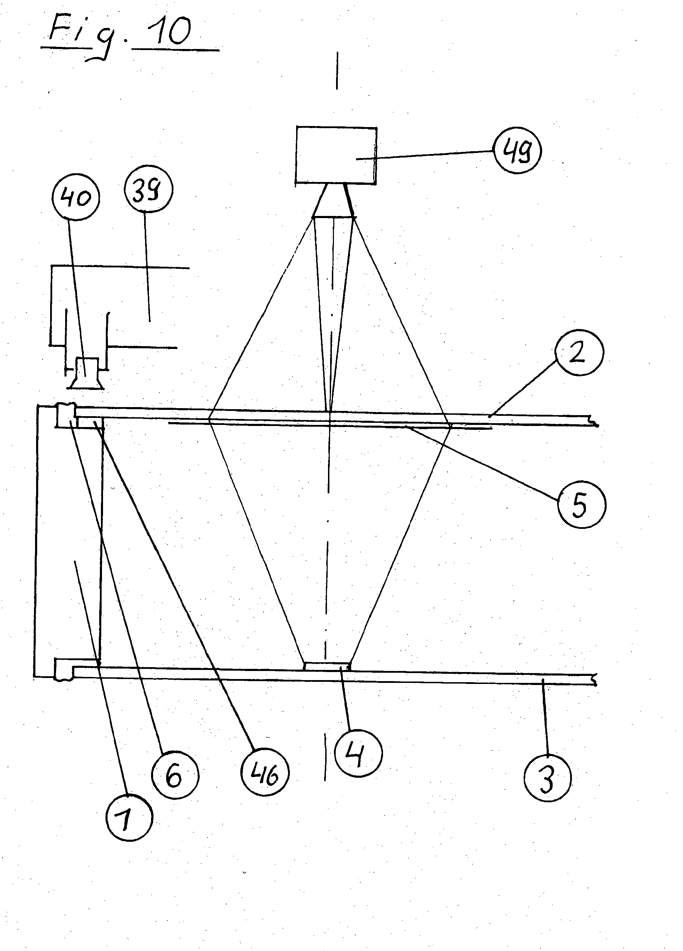

Fig. 10 bietet eine erläuternde Darstellung der Fixierung einer Sensorträgerscheibe 3. Neben einem Teil des Querschnitts eines Modulrahmens 1, einer Sensorträgerscheibe 3 und einer Linsenscheibe 2, ist hier ein Acrylpunkt 46 und die Silikondichtung 6 aufgezeigt. Stilisiert sind auf der linken Seite ein Saugerträger 39 und ein UV - Lichtstrahler 40 dargestellt. Mittels einer Kamera 49 wird die Linsenscheibe 2 so ausgerichtet, und dann mittels der Aushärtung entsprechender Acrylpunkte 46 fixiert, dass die Mittelpunkte aller Fresnel - Linsen 5 exakt auf die Mitte der entsprechenden CPV - Sensoren gerichtet sind.

Diese Ausrichtung kann rein optisch erfolgen, indem die Linsenscheibe 2 derart justiert wird, dass die Lage der optischen Achse ihrer Fresnel - Linsen 5 auf den geometrischen Mittelpunkt entsprechender CPV - Sensoren trifft.

Diese Ausrichtung kann aber auch auf andere Weise erfolgen, nämlich derart, dass ausgewählte CPV - Sensoren selbst mit Spannung beaufschlagt werden, worauf das von ihnen über die Fresnel - Linsen ausgesandte Licht erfasst wird und die Linsenscheibe 2 derart justiert wird, dass die Ausstrahlung besonderer strategisch wichtiger Fresnel - Linsen 5 ein Maximum wird. Zu diesem Zweck ist eine Einrichtung zur Erfassung der jeweiligen Scheibenposition einer Linsenscheibe 2 in Bezug zur Lage der Sensorträgerscheibe 3 und zur Erfassung der Positioniermechanismen notwendig. Solche Einrichtungen sind dem Fachmann geläufig und deshalb nicht dargestellt. Die Steuerungssignale einer solchen Einrichtung werden zur Ansteuerung des Übergaberoboters 19 für Sensorträgerscheiben 3 herangezogen.

Die Steuerung der komplexen Bewegungsvorgänge und die Signalverarbeitung der verwendeten Sensoren erfordern ein spezielles Steuerungsprogramm.

### Bezugszeichenliste

- 1: Modulrahmen
- 2: Linsenscheibe
- 3: Sensorträgerscheibe ( Bodenplatte )
- 4: CPV - Sensoren
- 5: Fresnel - Linsen
- 6: Silikondichtung
- 7: Teststation für Dichtungsprüfung, Etkettierung
- 8: vorderer Hubtisch für die Lafetten ( 5 Ebenen ) ------ vgl.27
- 9: Auflegeeinrichtung für Modulrahmen ( auf Lafette )
- 10: Station für Nachbearbeitung ( Silikon - Entfernung )
- 11: Hubtische der Bearbeitungsstationen ( 2 Ebenen )
- 12: Station für manuelle Kontaktierung ( Bearbeitung )
- 13: Station für mechanische, automatische Kontaktierung
- 14: Querförder - Einrichtung für Lafetten
- 15: Vorrichtung zum Auftrag von Acryl und Silikon
- 16: Auflege - Einrichtung für eine Sensorträgerscheibe 3
- 17: Auflege - Einrichtung für die Linsenscheibe 2
- 18: Magazin für Sensorträgerscheiben
- 19: Übergaberoboter für Sensorträgerscheiben
- 20: Übergaberoboter für Linsenscheiben
- 21: Sauggreifer für Sensorträgerscheiben ( Roboterübergabe )
- 22: Magazin für Linsenscheiben
- 23: Sauggreifer für Linsenscheiben ( Roboterübergabe )
- 24: Magazin für Modulrahmen
- 25: Portalumsetzer für Modulrahmen
- 26: Lagerstationen ( 4 Ebenen )
- 27: hinterer Hubtisch für Lafetten ( 5 Ebenen ) ----- vgl.8
- 28: Portalumsetzer für Endabstapelung ( 4 Plätze )
- 29: Abstapelplätze ( 4 Qualitäts - Stufen )
- 30: Lafette als Träger für Modulrahmen 1
- 31: Spannelement
- 32: Schaltstange
- 33: Schiebekeil
- 34: Druckfeder
- 35: Exzenterscheibe
- 36: Magnet
- 37: Anschlagelement
- 38: Spannriegel
- 39: Sauger - Träger
- 40: UV - Lichtstrahler
- 41: Sauger
- 42: Halteplatte
- 43: Gummibalg
- 44: Dichtring
- 45: Saugerkopf
- 46: Acryl
- 47: Acrylauftrag - Einrichtung
- 48: Silikonauftrag - Einrichtung
- 49: Kamera
- 50: Stellmotor

## Patentansprüche

1. Vorrichtung zur industriellen Herstellung von photovoltaischen Konzentratormodulen, bestehend aus einem Modulrahmen, einer Linsenscheibe mit einer Vielzahl von Fresnel-Linsen, einer Sensor trägerscheibe und einer elektrischen Leitungsführung, mit den folgenden Merkmalen:
h) eine Lafette (30) zur spannungsfreien Halterung eines Modulrahmens (1) mittels Spannelementen (31) auf beiden Längsseiten und Anschlagelementen (37) auf beiden Querseiten, wobei die Einstellung der Spannelemente (31) mittels des Verschiebens und Drehens einer Schaltstange (32) geschieht,
i) eine Einrichtung (47) für einen punktuellen Auftrag von Acryl und einen linearen Auftrag von Silikon (48) auf die Auflageflächen des Modulrahmens (1),
j) jeweils eine Einrichtung zum Auflegen der Sensorträgerscheibe (3) oder der Linsenscheibe (2), wobei diese Scheiben mittels spezieller Saugvorrichtungen (39) spannungsfrei transportiert und mit einem, zentral ansetzenden, vorbestimmten Anpressdruck aufgesetzt werden,
k) eine Einrichtung zum Vermessen der jeweiligen Scheibenposition und zur Positionierung der Sensorträgerscheibe (3) oder der Linsenscheibe (2),
l) eine Einrichtung zur Feinjustierung der Linsenscheibe (2) in Bezug auf CPV - Sensoren (4) der Sensorträgerscheibe (3), wobei ausgewählte CPV-Sensoren mit einer Spannung beaufschlagt werden, worauf das von ihnen über die Fresnel-Linsen (5) ausgesandte Licht erfasst wird und die Linsenscheibe (2) derart justiert wird, dass die Ausstrahlung besonderer strategisch wichtiger Fresnel-Linsen (5) ein Maximum wird,
m) eine Einrichtung zum Aushärten des Silikonauftrags zwischen dem Modulrahmen (1) und der jeweiligen Scheibe mittels mehrerer UV-Lichtstrahler (40),
n) Einrichtungen zum Transport der zu bearbeitenden Werkstücke.

2. Vorrichtung nach Anspruch 1,
**dadurch gekennzeichnet,**
**dass** die Saugvorrichtung (39) zum Transport der Scheiben so gestaltet ist, dass jeder Saugerkopf (45) aus festem Material besteht und die von einem Dichtring (44) begrenzte Fläche eben und beliebig geformt ist.

3. Vorrichtung nach einem der vorhergehenden Ansprüche,
**dadurch gekennzeichnet,**
**dass** die Grundeinstellung der Spannelemente (31) mittels des Verschiebens einer Schaltstange (32), über eine auf der Schaltstange befestigte Exzenter - Scheibe (35) und einen, von dieser kontaktierten, Schiebekeil (33) erfolgt.

4. Vorrichtung nach einem der vorhergehenden Ansprüche,
**dadurch gekennzeichnet,**
**dass** bei der spannungsfreien Halterung einer Lafette (30) die auftretenden Druckkräfte mittels Sensoren erfasst werden und die gewünschten Druckkräfte mittels der Schaltstange (32) und vier Stellmotoren (50) auf jeder Längsseite automatisch eingestellt werden.

5. Verfahren zur industriellen Herstellung von photovoltaischen Konzentratormodulen, bestehend aus einem Modulrahmen, einer Linsenscheibe mit einer Vielzahl von Fresnel-Linsen, einer Sensor trägerscheibe und einer elektrischen Leitungsführung, mit den folgenden Merkmalen:
i) es wird eine Lafette (30) bereitgestellt, ein Modulrahmen (1) aufgesetzt, und dieser auf den Querseiten mittels Anschlagelementen (37) und auf den Längsseiten mittels Spannelementen (31) spannungsfrei gehaltert,
j) die Lafette (30) wird mittels einer Querförder - Einrichtung (14) zu einer Einrichtung (47) für einen punktuellen Auftrag von Acryl und einen linearen Auftrag von Silikon (48) verfahren, wobei das Acryl und das Silikon auf die oben liegende Auflagefläche eines Modulrahmens (1) aufgetragen wird,
k) hierauf erfolgt ein Auflegen der Sensorträgerscheibe (3) auf den Modulrahmen (1) mittels eines Übergaberoboters (19) und einer Auflage - Einrichtung (16), wobei diese die Sensorträgerscheibe (3) mittels speziellen Saugvorrichtungen (39) spannungsfrei befördern, mit einem, zentral ansetzenden, vorbestimmten Anpressdruck aufsetzt und positioniert, und dann die Acrylpunkte zur Fixierung mittels UV - Lichtstrahler (40) aushärtet,
l) der Modulrahmen (1) wird der Lafette (30) entnommen, in eine vertikale Position gebracht, mit einem elektrischen Verteilerkasten und den Anschlüssen entsprechender Flachbandkabel versehen, und dann in horizontaler Lage in einer Lafette (30) mittels der Querförder - Einrichtung (14) zu der Einrichtung (47) für einen punktuellen Auftrag von Acryl und einen linearen Auftrag von Silikon (48) verfahren, wobei das Acryl und das Silikon auf die zweite, nunmehr oben liegende, Auflagefläche des Modulrahmens (1) aufgetragen wird,
m) hierauf erfolgt ein Auflegen der Linsenscheibe (2) auf den Modulrahmen mittels eines Übergaberoboters (20) und einer Auflege - Einrichtung (17), wobei diese die Linsenscheiben (2) mittels speziellen Saugvorrichtungen (39) spannungsfrei befördern,
n) danach erfolgt eine Feinjustierung der Linsenscheibe (2) in Bezug auf die Ausrichtung zu entsprechenden CPV - Sensoren (4) der Sensorträgerscheibe (3), wobei ausgewählte CPV-Sensoren mit einer Spannung beaufschlagt werden, worauf das von ihnen über die Fresnel-Linsen (5) ausgesandte Licht erfasst wird und die Linsenscheibe (2) derart justiert wird, dass die Ausstrahlung besonderer strategisch wichtiger Fresnel-Linsen (5) ein Maximum wird,
o) sodann wird die Linsenscheibe (2) mit einem, zentral ansetzenden, vorbestimmten Anpressdruck beaufschlagt und die Acrylpunkte zur Fixierung werden mittels UV - Lichtstrahler (40) ausgehärtet,
p) zuletzt wird den fertigen Konzentratormodulen Zeit zur Aushärtung des Silikons gegeben, und danach erfolgen eine qualitätsorientierte Sortierung, eine Konfektionierung und der Versand.

6. Verfahren nach Anspruch 5,
**dadurch gekennzeichnet,**
**dass** die auftretenden Druckkräfte auf den Längsseiten eines Modulrahmens (1) mittels Sensoren erfasst werden und die gewünschten Druckkräfte an den Spannelementen (31) automatisiert eingestellt werden.

7. Steuerungsprogramm mit einem Programmcode zur Durchführung der Verfahrensschritte nach Anspruch 5 oder 6, wenn das Programm in einem Computer ausgeführt wird.

8. Maschinenlesbarer Träger mit einem Programmcode eines Steuerungsprogramms zur Durchführung des Verfahrens nach Anspruch 5 oder 6, wenn das Programm in einem Computer ausgeführt wird.

## Claims

1. Device for industrially producing photovoltaic concentrator modules consisting of a module frame, a lens pane having a plurality of Fresnel lenses, a sensor carrier pane, and an electric line guide, comprising the following features:
h) a carriage (30) for holding a module frame (1) in a tension-free manner by means of clamping elements (31) on both longitudinal sides and stop elements (37) on both transverse sides, wherein the clamping elements (31) are adjusted by displacing and rotating a control rod (32),
i) an arrangement (47) for applying acryl in dots and an arrangement (48) for applying silicone in lines onto the support surfaces of the module frame (1),
j) an arrangement for laying the sensor carrier pane (3) or the lens pane (2), wherein these panes are transported in a tension-free manner by means of special suction devices (39) and are set down with a centrally-positioned predetermined contact pressure,
k) an arrangement for measuring the respective pane position and for positioning the sensor carrier pane (3) or the lens pane (2), 1) an arrangement for finely adjusting the lens pane (2) relative to CPV sensors (4) of the sensor carrier pane (3), wherein a voltage is applied to selected CPV sensors, whereupon the light emitted therefrom via the Fresnel lenses (5) is detected and the lens pane (2) is adjusted in such a way that the emission from particularly strategically important Fresnel lenses (5) is at a maximum,
m) an arrangement for curing the applied silicone between the module frame (1) and the respective pane by means of a plurality of UV light emitters (40),
n) arrangements for transporting the workpieces to be processed.

2. Device according to Claim 1,
**characterized in that**
the suction device (39) for transporting the panes is designed such that each sucker head (45) consists of solid material and the area delimited by a ring seal (44) is flat and arbitrarily shaped.

3. Device according to one of the preceding claims,
**characterized in that**
the basic adjustment of the clamping elements (31) is performed by displacing a control rod (32), via an eccentric (35) fastened on the control rod and a spline (33) contacted thereby.

4. Device according to one of the preceding claims,
**characterized in that**,
as the carriage (30) holds a module frame in a tension-free manner, the compressive forces occurring are detected by means of sensors and the desired compressive forces are automatically adjusted by means of the control rod (32) and four servomotors (50) on each longitudinal side.

5. Method for industrially producing photovoltaic concentrator modules consisting of a module frame, a lens pane comprising a plurality of Fresnel lenses, a sensor carrier pane and an electric line guide, comprising the following features:
i) a carriage (30) is provided, a module frame (1) is set down and is held in a tension-free manner on the transverse sides by means of stop elements (37) and on the longitudinal sides by means of clamping elements (31),
j) the carriage (30) is moved by means of a transverse conveying arrangement (14) to an arrangement (47) for applying acryl in dots and an arrangement (48) for applying silicone in lines, wherein the acryl and the silicone are applied to the upper support surface of a module frame (1),
k) the sensor carrier pane (3) is then laid onto the module frame (1) by means of a transfer robot (19) and a laying arrangement (16), wherein these convey the sensor carrier pane (3) in a tension-free manner by means of special suction devices (39), the sensor carrier pane is set down and positioned with a centrally positioned predetermined contact pressure, and then the acryl dots for fixing are cured by means of UV light emitters (40),
1) the module frame (1) is removed from the carriage (30), is brought into a vertical position, provided with an electric distribution box and flat ribbon cable in accordance with the connections, and is then moved in a horizontal position in a carriage (30) by means of the transverse conveying arrangement (14) to the arrangement (47) for applying acryl in dots and the arrangement (48) for applying silicone in lines, wherein the acryl and the silicone are applied to the second, now upper, support surface of the module frame (1),
m) the lens pane (2) is laid onto the module frame by means of a transfer robot (20) and a laying arrangement (17), wherein these convey the lens panes (2) in a tension-free manner by means of special suction devices (39),
n) the lens pane (2) is then finely adjusted relative to the alignment with corresponding CPV sensors (4) of the sensor carrier pane (3), wherein a voltage is applied to selected CPV sensors, whereupon the light emitted therefrom via the Fresnel lenses (5) is detected and the lens pane (2) is adjusted in such a way that the emission from particularly strategically important Fresnel lenses (5) is at a maximum,
o) a centrally positioned predetermined contact pressure is then applied to the lens pane (2), and the acryl dots for fixing are cured by means of UV light emitters (40),
p) the finished concentrator modules are then given time for the silicone to cure, and a quality-oriented sorting process, packaging and dispatch are then performed.

6. Method according to Claim 5,
**characterized in that**
the compressive forces occurring on the longitudinal sides of a module frame (1) are detected by means of sensors, and the desired compressive forces at the clamping elements (31) are adjusted in an automated manner.

7. Control program with a program code for carrying out the method steps according to Claim 5 or 6 if the program is run in a computer.

8. Machine-readable carrier with a program code of a control program for carrying out the method according to Claim 5 or 6 if the program is run in a computer.

## Revendications

1. Dispositif pour la fabrication industrielle de modules concentrateurs photovoltaïques, se composant d'un cadre de module, d'une plaque de lentilles avec une pluralité de lentilles de Fresnel, d'une plaque de support de capteurs et d'un câblage électrique, avec les caractéristiques suivantes ;
h) un affût (3) pour la fixation sans contrainte d'un cadre de module (1) au moyen d'éléments de serrage (31) sur les deux côtés longitudinaux et d'éléments de butée (37) sur les deux côtés transversaux, le réglage des éléments de serrage (31) s'effectuant au moyen du déplacement et de la rotation d'une tige de commande (32),
i) un dispositif (47) pour une application ponctuelle d'acrylique et une application linéaire de silicone (48) sur les surfaces d'appui du cadre de module (1),
j) respectivement un dispositif pour la pose de la plaque de support de capteurs (3) ou de la plaque de lentilles (2), ces plaques étant transportées sans contrainte au moyen de dispositifs d'aspiration spéciaux (39) et étant mises en place avec une pression d'application prédéfinie appliquée centralement,
k) un dispositif pour mesurer la position de plaque respective et pour le positionnement de la plaque de support de capteurs (3) ou de la plaque de lentilles (2),
1) un dispositif pour l'ajustement de précision de la plaque de lentilles (2) par rapport aux capteurs CPV (4) de la plaque de support de capteurs (3), des capteurs CPV sélectionnés étant alimentés par une tension, suite à quoi la lumière émise par eux via les lentilles de Fresnel (5) est détectée et la plaque de lentilles (2) étant ajustée de manière à ce que le rayonnement de lentilles de Fresnel (5) particulières stratégiquement importantes devienne un maximum,
m) un dispositif pour faire durcir l'application de silicone entre le cadre de module (1) et la plaque respective au moyen de plusieurs émetteurs de lumière UV (40),
n) des dispositifs pour le transport des pièces à travailler.

2. Dispositif selon la revendication 1,
**caractérisé en ce que**
le dispositif d'aspiration (39) pour le transport des plaques est conçu de manière à ce que chaque tête d'aspiration (45) se compose d'un matériau solide et que la surface délimitée par une bague d'étanchéité (44) est formée de manière plane et au choix.

3. Dispositif selon l'une des revendications précédentes,
**caractérisé en ce que**
le réglage de base des éléments de serrage (31) s'effectue au moyen du déplacement d'une tige de commande (32) via un disque d'excentrique (35) fixé sur la tige de commande et une clavette coulissante (33) contactée par celui-ci.

4. Dispositif selon l'une des revendications précédentes, **caractérisé en ce que**, lors de la fixation sans contrainte d'un affût (30), les forces de pression apparaissant sont détectées à l'aide de capteurs et les forces de pression souhaitées sont réglées automatiquement sur chaque côté longitudinal au moyen de la tige de commande (32) et de quatre moteurs de positionnement (50).

5. Procédé pour la fabrication industrielle de modules concentrateurs photovoltaïques, se composant d'un cadre de module, d'une plaque de lentilles avec une pluralité de lentilles de Fresnel, d'une plaque de support de capteurs et d'un câblage électrique, avec les caractéristiques suivantes ;
i) un affût (30) est mis à disposition, un cadre de module (1) est apposé, et celui-ci étant fixé sans contrainte sur les côtés transversaux au moyen d'éléments de butée (37) et sur les côtés longitudinaux au moyen d'éléments de serrage (31),
j) l'affût (30) étant déplacé au moyen d'un dispositif de transport transversal (14) vers un dispositif (47) pour une application ponctuelle d'acrylique et une application linéaire de silicone (48), l'acrylique et le silicone étant appliqués sur la surface d'appui située en-haut d'un cadre de module (1),
k) suite à cela, il s'en suit une pose de la plaque de support de capteurs (3) sur le cadre de module (1) au moyen d'un robot de transfert (19) et d'un dispositif de pose (16), ceux-ci transportant sans contrainte la plaque de support de capteurs (3) au moyen de dispositifs d'aspiration (39) spéciaux, la mettant en place avec une pression d'application prédéterminée appliquée centralement et la positionnant, et faisant ensuite durcir les points d'acrylique pour la fixation au moyen d'émetteurs de lumière UV (40),
1) le cadre de module (1) étant prélevé de l'affût (30), étant amené dans une position verticale, étant muni d'un boîtier de distribution électrique et des raccordements de câbles plats correspondants, et étant ensuite déplacé dans une position horizontale dans un affût (30) au moyen du dispositif de transport transversal (14) jusqu'au dispositif (47) pour une application ponctuelle d'acrylique et une application linéaire de silicone (48), l'acrylique et le silicone étant appliqués sur la deuxième surface d'appui, se situant à présent en-haut, du cadre de module (1),
m) suite à cela, il s'en suit une pose de la plaque de lentilles (2) sur le cadre de module au moyen d'un robot de transfert (20) et d'un dispositif de pose (17), ceux-ci transportant sans contrainte les plaques de lentilles (2) au moyen de dispositifs d'aspiration (39) spéciaux,
n) suite à quoi il y a un ajustement de précision de la plaque de lentilles (2) en vue de l'orientation par rapport à des capteurs CPV (4) correspondants de la plaque de support de capteurs (3), des capteurs CPV sélectionnés étant alimentés par une tension, suite à quoi la lumière émise par eux via les lentilles de Fresnel (5) est détectée et la plaque de lentilles (2) étant ajustée de manière à ce que le rayonnement de lentilles de Fresnel (5) particulières stratégiquement importantes devienne un maximum,
o) la plaque de lentilles (2) étant alors soumise à une pression d'application prédéterminée, appliquée centralement, et les points d'acrylique pour la fixation étant durcis au moyen d'émetteurs de lumière UV (40),
p) du temps étant finalement accordé aux modules concentrateurs achevés pour le durcissement du silicone, et s'en suivant ensuite un tri qualitatif, un conditionnement et l'expédition.

6. Procédé selon la revendication 5,
**caractérisé en ce que**
les forces de pression apparaissant sur les côtés longitudinaux d'un cadre de module (1) sont détectées au moyen de capteurs et **en ce que** les forces de pression souhaitées sont réglées automatiquement au niveau des éléments de serrage (31).

7. Programme de commande avec un code de programme pour l'exécution des étapes du procédé selon la revendication 5 ou 6 lorsque le programme est exécuté sur un ordinateur.

8. Support lisible par machine avec un code de programme d'un programme de commande pour l'exécution du procédé selon la revendication 5 ou 6 lorsque le programme est exécuté par un ordinateur.
